# EUROPEAN PATENT APPLICATION

(11) **EP 2 226 680 A1**
(43) Date of publication of application: **08.09.2010**
(21) Application number: 08839062.0
(22) Date of filing: 25.08.2008
(51) Int. Cl.: G03F 7/004, G03F 7/00, G03F 7/11

(54) **POSITIVE LITHOGRAPHIC PRINTING PLATE PRECURSOR AND METHOD FOR PRODUCING THE SAME**

(30) Priority: 16.10.2007 JP 2007269299
(71) Applicant: Eastman Kodak Company, Rochester, NY 14650 (US)
(72) Inventor: MIYAMOTO, Yasushi, Oura-gun Gunma 370-0723 (JP); ASAWA, Yasuhiro, Oura-gun Gunma 370-0723 (JP); ABURANO, Maru, Oura-gun Gunma 370-0723 (JP); HAYAKAWA, Eiji, Oura-gun Gunma 370-0723 (JP); HOTATE, Shouichi, Oura-gun Gunma 370-0723 (JP)
(74) Representative: Vossius & Partner
(86) International application number: PCT/JP2008/065608
(87) International publication number: WO 2009/050947

(57) **Abstract**

An object of the present invention is to provide a CTP positive working lithographic printing original plate capable of developing using a negative developing solution.

The present invention provides a positive working lithographic printing original plate having (1) a substrate thereon (2) a lower layer containing a water-insoluble and alkali-soluble resin and a photothermal conversion material, and (3) an uppermost layer containing a water-insoluble and alkali-soluble resin, wherein
the lower layer contains (a) a polymer having a perfluoroalkyl group and/or (b) a polymer having a siloxane group.

## Description

### TECHNICAL FIELD

The present invention relates to a lithographic printing original plate and a plate-making method, and more particularly relates to an infrared-sensitive or heat-sensitive lithographic printing original plate, which is used as a so-called CTP (computer to plate) plate capable of directly forming an image by being irradiating with infrared rays from a solid-state laser or a diode laser based on digital signals. Especially the present invention relates to a positive working lithographic printing original plate.

### BACKGROUND ART

As a lithographic printing original plate, for example, a lithographic printing original plate (i.e., PS plate) comprising a photosensitive image forming layer has hitherto been known. A PS plate basically includes two types of plates: negative working plates and positive working plates. In a negative working plate, a negative film is used upon exposure and is developed with a developing solution for a negative working plate to remove the unexposed area of the photosensitive layer, and thus the area insolubilized by exposure remains as an image. In a positive working plate, a positive film is used upon exposure and then developed with a developing solution for a positive working plate to remove the exposed area which is solubilized by exposure, and thus the unexposed area remains as an image.

The developing solution for a positive working plate is a high-pH aqueous solution, which usually contains inorganic strong alkali components, such as silicates, phosphates, carbonates and hydroxides of alkali metals, for example, sodium hydroxide, potassium hydroxide, sodium carbonate, sodium silicate, potassium silicate, sodium methasilicate, and tertiary sodium phosphate. In contrast, although this depends on the composition of the negative working plate, the developing solution for a negative working plate usually contains water as a main component, contains a small amount of an organic solvent, and also contains organic amines and a surfactant. The developing solution for a negative working plate does not contain an inorganic strong alkali component and is a relatively low-pH (7 to 11.5) aqueous solution.

With the progress of computer image processing technology, a method of directly writing an image on an image forming layer by light irradiation in response to digital signals has recently been developed. Intense interest has been shown towards a CTP system in which an image is directly formed on a lithographic printing original plate without outputting to a silver type mask film utilizing this method to the lithographic printing original plate. The CTP system using high-output laser having a maximum intensity in a near infrared or infrared region as a light source for light irradiation has an advantage that a high-resolution image can be obtained by exposure within a short time and the lithographic printing original plate used for the system can be treated in a daylight room. Now high-output and portable solid state and diode lasers capable of irradiating infrared rays having a wavelength of 760 to 1200 nm are easily obtainable.

In the positive working lithographic printing original plate of the CTP system, in order to improve characteristics of the positive working lithographic printing original plate in each step of exposing, developing, plate-making and printing steps, there has been made a trial of attaining desired characteristics by employing two-layered configuration of a lower layer and an upper layer as the configuration of an image forming layer and varying the component formula of the lower layer and the upper layer.

For example, Japanese Unexamined Patent Publication (Kokai) No. 2000-131831 discloses a heat mode image forming element in which an uppermost layer has IR-sensitivity and is impermeable to an aqueous alkali developing solution, while a lower layer contains a soluble polymer in an aqueous alkali solution, and at least one of the lower layer and the uppermost layer contains a surfactant.

Japanese Unexamined Patent Publication (Kokai) No. 2000-221669 and Japanese Unexamined Patent Publication (Kokai) No. 2000-221670 disclose a method for producing a lithographic printing plate in which an uppermost layer has IR-sensitivity and is impermeable to an aqueous alkali developing solution and also contains a siloxane surfactant, while a lower layer contains a polymer soluble in an aqueous alkali solution and a siloxane surfactant.

Japanese Unexamined Patent Publication (Kokai) No. 2003-29412 discloses an original plate for a positive working lithographic printing plate in which an upper heat-sensitive layer contains a water-insoluble and alkali-soluble resin, an infrared ray absorbing dye and a surfactant, while a lower layer contains a water-insoluble and alkali-soluble resin and a surfactant.

Japanese Unexamined Patent Publication (Kokai) No. 2003-84430 discloses a thermally imageable element in which an upper layer contains a first polymer material, is ink receptive and is insoluble in an aqueous alkali developing solution, while an absorbing layer as a lower layer is comprising of a photothermal conversion material or a mixture of photothermal conversion materials and, optionally, a surfactant or a mixture of surfactants.

Japanese Unexamined Patent Publication (Kokai) No. 2002-196491 discloses a photosensitive image-forming material for an infrared laser, comprising a layer containing 50% by mass or more of a copolymer and a compound which absorbs light to generate heat, and a layer containing 50% by mass or more of an aqueous alkali solution-soluble resin having a phenolic hydroxyl group and a compound which absorbs light to generate heat, these layers being sequentially laminated.

The positive working lithographic printing original plate of the CTP system is usually developed using a developing solution with a composition similar to a developing solution for a positive working PS plate. The developing solution for a positive working PS plate, for example, is a high-pH solution containing inorganic strong alkali components such as silicates, phosphates, carbonates, and hydroxides of alkali metals. It is known that, when the developing solution for a positive working PS plate is used, inorganic strong alkali components may cause generation of aluminum sludge. Furthermore, the positive developing solution easily deteriorates and must be replaced within a short period.

In contrast, since the developing solution for a negative working PS plate (hereinafter referred to as a "negative developing solution") does not contain inorganic strong alkali components and is not a high-pH solution, the problem above peculiar to the positive working PS plate developing solution does not arise. There is an advantage that there is a long replacement cycle for developing solutions. Therefore, some trials for developing a CTP positive working lithographic printing plate using a negative developing solution have been made. However, satisfactory results are not obtained because of low sensitivity (combining an exposure speed and a developing speed).

### DISCLOSURE OF THE INVENTION

Thus, an object of the present invention is to provide a CTP positive working lithographic printing original plate capable of developing using a negative developing solution. Another object is to provide a high-sensitivity infrared-sensitive or heat-sensitive positive working lithographic printing original plate.

The present invention provides a positive working lithographic printing original plate having (1) a substrate thereon (2) a lower layer containing a water-insoluble and alkali-soluble resin and a photothermal conversion material, and (3) an uppermost layer containing a water-insoluble and alkali-soluble resin, wherein
the lower layer contains (a) a polymer having a perfluoroalkyl group and/or (b) a polymer having a siloxane group.

The present invention also provides a plate-making method of a positive working lithographic printing original plate, which comprises imagewise exposing A positive working lithographic printing original plate having (1) a substrate thereon (2) a lower layer containing a water-insoluble and alkali-soluble resin and a photothermal conversion material, and (3) an uppermost layer containing a water-insoluble and alkali-soluble resin, wherein the lower layer contains (a) a polymer having a perfluoroalkyl group and/or (b) a polymer having a siloxane group, and developing the positive working lithographic printing plate with a developing solution for a negative working PS plate.

### EFFECTIVE OF THE INVENTION

The lithographic printing original plate of the present invention has high sensitivity. When the term "sensitivity" is used in the present description, it means efficiency when exposure speed and developing speed are combined. High sensitivity of the lithographic printing original plate means that an image can be formed under low exposure energy and also means that energy efficiency from exposure to plate-making is high.

Furthermore, the lithographic printing original plate of the present invention can be made using a developing solution for a negative working PS plate. In the plate-making method of the present invention, aluminum sludge is not generated upon development and the frequency of replacement of the developing solution decreases.

### BEST MODE FOR CARRYING OUT THE INVENTION

The lithographic printing original plate of the present invention comprises a lower layer on a substrate, and comprises an uppermost layer on the lower layer. The lower layer and the uppermost layer constitute an image forming layer of the lithographic printing original plate. Between the substrate and the lower layer, an intermediate layer may be formed, if necessary. It is preferred that the intermediate layer does not exist between the lower layer and the uppermost layer. On a back surface of the substrate, a backcoat layer may be formed, if necessary. In view of simplification of the production of the original plate, it is preferred that the lower layer is formed in contact with a surface of the substrate and the uppermost layer is formed in contact with a surface of the lower layer.

### <Lower Layer>

The lower layer constituting the lithographic printing original plate of the present invention contains a resin which is soluble or dispersible in an alkali aqueous solution. It is preferred that the resin has at least a functional group such as a phenolic hydroxyl group, a carboxyl group, a sulfonic acid group, a phosphoric acid group, a phosphonic acid group, an active imino group, or a sulfonamide group so as to make the resin to be soluble or dispersible in an alkali aqueous solution. Therefore, a resin which is soluble or dispersible in an alkali aqueous solution used for the lower layer can be preferably produced by polymerizing a monomer mixture containing one or more ethylenically unsaturated monomers having a functional group such as a phenolic hydroxyl group, a carboxyl group, a sulfonic acid group, a phosphoric acid group, a phosphonic acid group, an active imino group, a sulfonamide group, and any combination thereof.

The ethylenically unsaturated monomer can be a compound represented by the following formula: 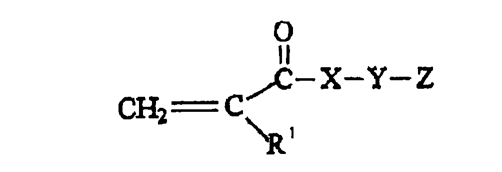 wherein R¹ represents a hydrogen atom, a C₁₋₂₂ linear, branched or cyclic alkyl group, a C₁₋₂₂ linear, branched or cyclic, substituted alkyl group, a C₆₋₂₄ aryl group or substituted aryl group, wherein the substituent is selected from a C₁₋₄alkyl group, an aryl group, a halogen atom, a keto group, an ester group, an alkoxy group, or a cyano group; X represents O, S or NR²; R² represents hydrogen, a C₁₋₂₂ linear, branched or cyclic alkyl group, a C₁₋₂₂ linear, branched or cyclic substituted alkyl group, a C₆₋₂₄ aryl group or substituted aryl group, wherein the substituent is selected from a C₁₋₄alkyl group, an aryl group, a halogen atom, a keto group, an ester group, an alkoxy group, or a cyano group; Y represent a single bond, or a C₁₋₂₂ linear, branched or cyclic alkylene, an alkyleneoxyalkylene, an poly(alkyleneoxy)alkylene, or an alkylene-NHCONH-; and Z represents a hydrogen atom, a hydroxyl group, carboxyl group, -C₆H₄-SO₂NH₂, -C₆H₃-SO₂NH₂ (-OH), -OPO₃H₂, -PO₃H₂, or a group represented by the following formula: 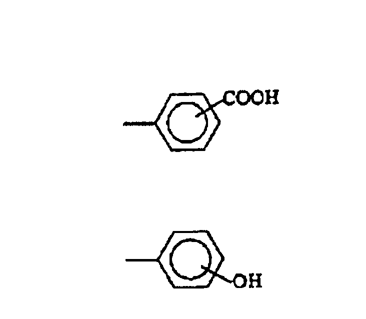 or 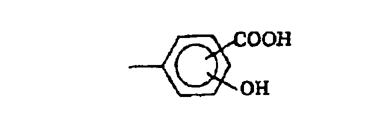 , or a mixture thereof.

Examples of the ethylenically unsaturated monomer include, in addition to acrylic acid and methacrylic acid, compounds represented by the following formulas, and a mixture thereof. 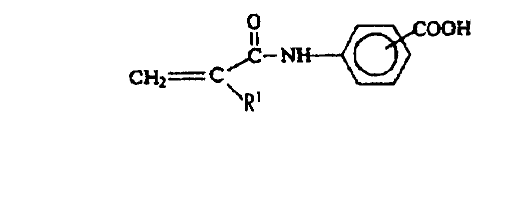 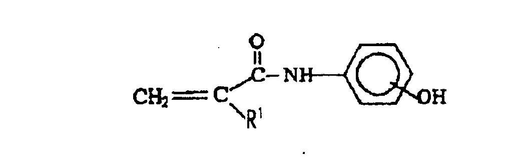 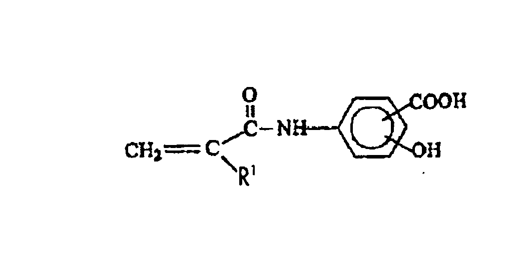 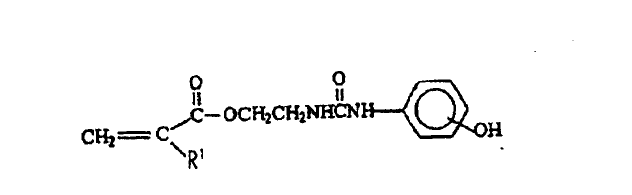 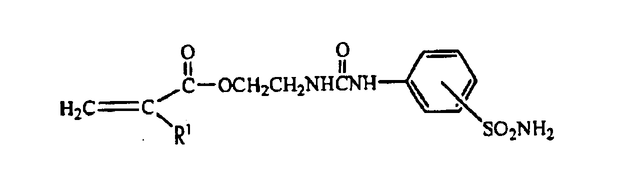 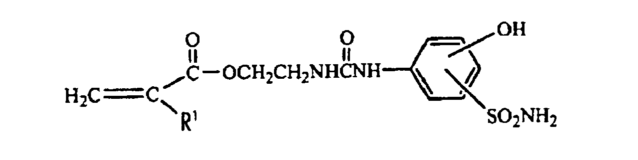 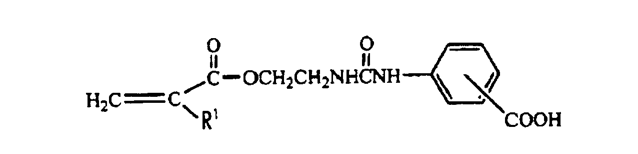 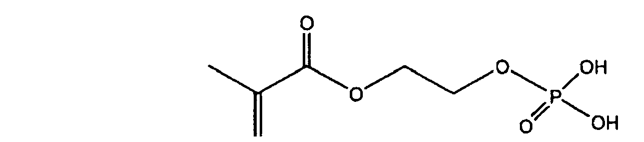 Ethylene glycol methacrylate phosphate ("Phosmer-M", manufactured by Uni-Chetnical Co., Ltd.) 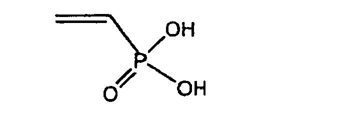 vinyl phosphonic acid 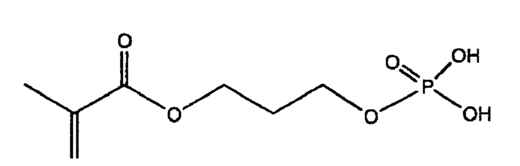 1,3-propylene glycol methacrylate phosphate 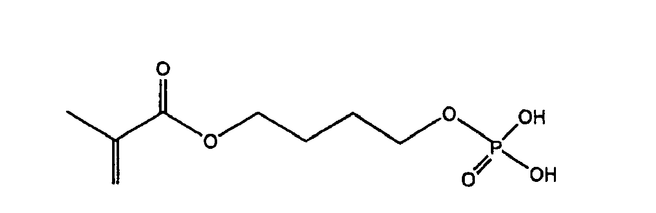 1,4-n-butylene glycol methacrylate phosphate

The monomer mixture can contain the other ethylenically unsaturated comonomers. Examples of the other ethylenically unsaturated comonomer include the following monomers:
acrylate esters such as methyl acrylate, ethyl acrylate, propyl acrylate, butyl acrylate, amyl acrylate, ethylhexyl acrylate, octyl acrylate, t-octyl acrylate, chloroethyl acrylate, 2,2-dimethylhydroxypropyl acrylate, 5-hydroxypentyl acrylate, trimethylolpropane monoacrylate, pentaerythritol monoacrylate, glycidyl acrylate, benzyl acrylate, methoxybenzyl acrylate, and tetrahydroacrylate;
aryl acrylates such as phenyl acrylate and furfuryl acrylate;
methacrylate esters such as methyl methacrylate, ethyl methacrylate, propyl methacrylate, isopropyl methacrylate, allyl methacrylate, amyl methacrylate, hexyl methacrylate, cyclohexyl methacrylate, benzyl methacrylate, chlorobenzyl methacrylate, octyl methacrylate, 4-hydroxybutyl methacrylate, 5-hydroxypentyl methacrylate, 2,2-dimethyl-3-hydroxypropyl methacrylate, trimethylolpropane monomethacrylate, pentaerythritol monomethacrylate, glycidyl methacrylate, furfuryl methacrylate, and tetrahydrofurfuryl methacrylate;
aryl methacrylates such as phenyl methacrylate, cresyl methacrylate, and naphthyl methacrylate;
N-alkylacrylamides such as N-methylacrylamide, N-ethylacrylamide, N-propylacrylamide, N-butylacrylamide, N-t-butylacrylamide, N-heptylacrylamide, N-octylacrylamide, N-cyclohexylacrylamide, and N-benzylacrylamide;
N-arylacrylamides such as N-phenylacrylamide, N-tolylacrylamide, N-nitrophenylacrylamide, N-naphthylacrylamide, and N-hydroxyphenylacrylamide; N,N-dialkylacrylamides such as N,N-dimethylacrylamide, N,N-diethylacrylamide, N,N-dibutylacrylamide, N,N-dibutylacrylamide, N,N-diisobutylacrylamide, N,N-diethylhexylacrylamide, and N,N-dicyclohexylacrylamide; N,N-arylacrylamides such as N-methyl-N-phenylacrylamide, N-hydroxyethyl-N-methylacrylamide, and N-2-acetamideethyl-N-acetylacrylamide; N-alkylmethacrylamides such as N-methylmethacrylamide, N-ethylmethacrylamide, N-propylmethacrylamide, N-butylmethacrylamide, N-t-butylmethacrylamide, N-ethylhexylmethacrylamide, N-hydroxyethylmethacrylamide, and N-cyclohexylmethacrylamide;
N-arylmethacrylamides such as N-phenylmethacrylamide and N-naphthylmethacrylamide;
N,N-dialkylmethacrylamides such as N,N-diethylmethacrylamide, N,N-dipropylmethacrylamide, and N,N-dibutylmethacrylamide;
N,N-diarylmethacrylamides such as N,N-diphenylmethacrylamide;
methacrylamide derivatives such as N-hydroxyethyl-N-methylmethacrylamide, N-methyl-N-phenylmethacrylamide, and N-ethyl-N-phenylmethacrylamide;
allyl compounds such as allyl acetate, allyl caproate, allyl caprylate, allyl laurate, allyl palmitate, allyl stearate, allyl benzoate, allyl acetoacetate, allyl lactate, and allyloxyethanol;
vinyl ethers such as hexyl vinyl ether, octyl vinyl ether, dodecyl vinyl ether, ethylhexyl vinyl ether, methoxyethyl vinyl ether, ethoxyethyl vinyl ether, chloroethyl vinyl ether, 1-methyl-2,2-dimethyl propyl vinyl ether, 2-ethylbutyl vinyl ether, hydroxyethyl vinyl ether, diethylene glycol vinyl ether, dimethylaminoethyl vinyl ether, diethylaminoethyl vinyl ether, butylaminoethyl vinyl ether, benzyl vinyl ether, tetrahydrofurfuryl vinyl ether, vinyl phenyl ether, vinyl tolyl ether, vinyl chlorophenyl ether, vinyl-2,4-dichlorophenyl ether, vinyl naphthyl ether, and vinyl anthranyl ether;
vinyl esters such as vinyl butyrate, vinyl isobutyrate, vinyltrimethyl acetate, vinyldiethyl acetate, vinyl valeate, vinyl caproate, vinyl chloroacetate, vinyl methoxyacetate, vinyl butoxyacetate, vinyl phenylacetate, vinyl acetoacetate, vinyl lactate, vinyl-β-phenylbutyrate, vinyl cyclohexylcarboxylate, vinyl benzoate, vinyl salicylate, vinyl chlorobenzoate, vinyl tetrachlorobenzoate, and vinyl naphthoate;
styrenes such as styrene, methylstyrene, dimethylstyrene, trimethylstyrene, ethylstyrene, diethylstyrene, isopropylstyrene, butylstyrene, hexylstyrene, cyclohexylstyrene, dodecylstyrene, benzylstyrene, chloromethylstyrene, trifluoromethylstyrene, ethoxymethylstyrene, acetoxymethylstyrene, methoxystyrene, 4-methoxy-3-methylstyrene, dimethoxystyrene, chlorostyrene, dichlorostyrene, trichlorostyrene, tetrachlorostyrene, pentachlorostyrene, bromostyrene, dibromostyrene, iodostyrene, fluorostyrene, 2-bromo-4-trifluoromethylstyrene, and 4-fluoro-3-trifluoromethylstyrene;
crotonate esters such as butyl crotonate, hexyl crotonate, crotonic acid, and glycerin monocrotonate; itaconic acid dialkyls such as dimethyl itaconate, diethyl itaconate, and dibutyl itaconate;
dialkyls of maleic acid or fumaric acid, such as dimethyl maleate and dibutyl fumarate;
N-maleimides such as N-methylmaleimide, N-ethylmaleimide, N-propylmaleimide, N-butylmaleimide, N-phenylmaleimide, N-2-methylphenylmaleimide, N-2,6-diethylphenylmaleimide, N-2-chlorophenylmaleimide, N-cyclohexylmaleimide, N-laurylmaleimide, and N-hydroxyphenylmaleimide; and nitrogen atom-containing monomers such as N-vinyl pyrrolidone, N-vinylpyridine, acrylonitrile, and methacrylonitrile.

Among these other ethylenically unsaturated comonomers, (meth)acrylate esters, (meth)acrylamides, maleimides, and (meth)acrylonitriles are preferably used.

A weight average molecular weight of the water-insoluble and alkali-soluble resin is preferably within a range from 20,000 to 100,000. When the weight average molecular weight of the water-insoluble and alkali-soluble resin is less than 20,000, solvent resistance and abrasion resistance may deteriorate. In contrast, when the weight average molecular weight of the water-insoluble and alkali-soluble resin is more than 100,000, alkali developability may deteriorate.

The content of the resin which is soluble or dispersible in an alkali aqueous solution in the lower layer is preferably within a range from 20 to 95% by mass based on the solid content of the layer. When the content of the resin, which is soluble or dispersible in an alkali aqueous solution, is less than 20% by mass, it is disadvantageous in view of chemical resistance. In contrast, when the content is more than 95% by mass, it is not preferred in view of the exposure speed. If necessary, two or more kinds of resins which are soluble or dispersible in an alkali aqueous solution may be used in combination.

### <Uppermost Layer>

The uppermost layer constituting the lithographic printing original plate of the present invention contains an alkali-soluble resin. The alkali-soluble resin, which can be used for the uppermost layer, is preferably a resin having a carboxylic acid group or an acid anhydride group and examples thereof include a copolymer obtained by polymerizing a monomer mixture containing an unsaturated carboxylic acid and/or an unsaturated carboxylic anhydride, and polyurethane having a substituent containing an acidic hydrogen atom. Examples of the unsaturated carboxylic acid and/or unsaturated carboxylic anhydride include acrylic acid, methacrylic acid, maleic acid, maleic anhydride, itaconic acid, and itaconic anhydride. Examples of the copolymerizable ethylenically unsaturated monomer unit include the above-mentioned other ethylenically unsaturated comonomers.

The acidic hydrogen atom of the polyurethane having a substituent containing an acidic hydrogen atom can belong to an acidic functional group such as a carboxyl group, a -SO₂NHCO group, a -CONHSO₂ group, a - CONHSO₂NH group, or a -NHCONHSO₂ group, and is particularly preferably an acidic hydrogen atom derived from a carboxy group.

The polyurethane having an acidic hydrogen atom can be synthesized, for example, by a method of reacting a diol having a carboxy group and, if necessary, another diol and diisocyanate; a method of reacting a diol, a diisocyanate having a carboxy group and, if necessary, another diisocyanate; or a method of reacting a diol having a carboxy group and, if necessary, another diol, or a diisocyanate having a carboxy group and, if necessary, another diisocyanate.

Examples of the diol having a carboxy group include 3,5-dihydroxybenzoic acid, 2,2-bis(hydroxymethyl)propionic acid, 2,2-bis(hydroxyethyl)propionic acid, 2,2-bis(3-hydroxypropylpropionic acid, 2,2-bis(hydroxymethyl)acetic acid, bis-(4-hydroxyphenyl)acetic acid, 4,4-bis-(4-hydroxyphenyl)pentanoic acid, and tartaric acid, and 2,2-bis(hydroxymethyl)propionic acid is particularly preferred in view of reactivity with the isocyanate.

Other diols include dimethylolpropane, polypropylene glycol, neopentyl glycol, 1,3-propanediol, polytetramethylene ether glycol, polyesterpolyol, polymerpolyol, polycaprolactonepolyol, polycarbonatediol, 1,4-butanediol, 1,5-pentadiol, 1,6-hexanediol, and polybutadienepolyol.

Examples of the diisocyanate having a carboxy group include dimer acid diisocyanate.

Examples of the other diisocyanate include 4,4'-diphenylmethane diisocyanate, xylylene diisocyanate, naphthylene-1,5-diisocyanate, tetramethylxylene diisocyanate, hexamethylene diisocyanate, toluene-2,4-diisocyanate, isophorone diisocyanate, hydrogenated xylylene diisocyanate, dicyclohexylmethane diisocyanate, norbornene diisocyanate, and trimethylhexamethylene diisocyanate.

The molar ratio of the diisocyanate to the diol is preferably from 0.7:1 to 1.5:1. When an isocyanate group remains at the end of the polymer, it is possible to synthesize by treating with alcohols or amines so that an isocyanate group does not finally remain.

A weight average molecular weight of the copolymer including an unsaturated carboxylic acid unit and/or an unsaturated carboxylic anhydride unit is preferably within a range from 800 to 10,000. When the weight average molecular weight of the copolymer including an unsaturated carboxylic acid unit and/or an unsaturated carboxylic anhydride unit is less than 800, the image area obtained by the image formation may become weak and inferior in developing solution resistance. In contrast, when the weight average molecular weight of the copolymer including an unsaturated carboxylic anhydride unit is more than 10,000, sensitivity may decrease.

A weight average molecular weight of the polyurethane having a substituent containing an acidic hydrogen atom is preferably within a range from 2,000 to 100,000. When the weight average molecular weight of the polyurethane is less than 2,000, the image area obtained by the image formation may become weak and show poor press life to printing. In contrast, when the weight average molecular weight of the polyurethane is more than 100,000, sensitivity may decrease.

The content of the copolymer including an unsaturated carboxylic acid unit and/or an unsaturated carboxylic anhydride unit in the uppermost layer is preferably within a range from 10 to 100% by mass based on the solid content of the layer. When the solid content of the copolymer including an unsaturated carboxylic acid unit and/or an unsaturated carboxylic anhydride unit is less than 10% by mass, it is disadvantageous and unpreferred in view of developing solution resistance.

In contrast, the content of the polyurethane including an unsaturated carboxylic acid unit and/or an unsaturated carboxylic anhydride unit is preferably within a range from 2 to 90% by mass based on the solid content of the layer. When the content of the polyurethane having a substituent containing an acidic hydrogen atom is less than 2% by mass, it is disadvantageous in view of a developing speed. In contrast, when the content is more than 90% by mass, it is not preferred in view of storage stability. If necessary, two or more kinds of polyurethanes having a substituent containing an acidic hydrogen atom may be used in combination. Furthermore, two or more kinds of copolymer including an unsaturated carboxylic anhydride unit, copolymers including an unsaturated carboxylic acid unit and copolymers having a substituent containing an acidic hydrogen atom may be used in combination.

### <Photothermal Conversion Material>

Although the lower layer of the lithographic printing original plate of the present invention contains a photothermal conversion material, the uppermost layer does not contain a photothermal conversion material. Therefore, it is considered that, when an image is written on the lithographic printing original plate of the present invention by laser, the photothermal conversion material of the lower layer converts the laser beam into heat and heat is transferred to the uppermost layer, and thus a partial molecular structure of the alkali-soluble resin of the uppermost layer collapses and forms pores in the uppermost layer thereby enabling permeation of the developing solution into the bottom layer. Since the uppermost layer does not contain the photothermal conversion material, heat is not generated as a result of the exposure of the laser beam.

The photothermal conversion material means any material capable of converting an electromagnetic energy into thermal energy. When used in the present invention, the photothermal conversion material is a material having a maximum absorption wavelength in a near infrared to infrared region, for example, a material having a maximum absorption wavelength within a range from 760 to 1200 nm. Examples of such a material include various pigments and dyes.

As the pigment which can be used in the present invention, there can be used commercially available pigments and those pigments described in the Color Index Manual "Saishin Ganryou Binran" (New Manual of Pigments) (edited by the Japan Pigment Technology Association, 1977), "Saishin Ganryou Ouyou Gijutsu" (New Applied Technology for Pigment) (CMC Publishing, 1986), "Insatsu Inki Gijutsu" (Printing Ink Technology) (CMC Publishing, 1984), etc. As the pigment, black pigments, yellow pigments, orange pigments, brown pigments, red pigments, violet pigments, blue pigments, green pigments, fluorescent pigments, and other polymer bond pigments are listed. Specifically, there can be used insoluble azo pigments, azolake pigments, condensed azo pigments, chelate azo pigments, phthalocyanine pigments, anthraquinone pigments, perylene and perynone pigments, thioindigo pigments, quinacridone pigments, dioxazine pigments, isoindolinone pigments, quinophthalone pigments, staining lake pigments, azine pigments, nitroso pigments, nitro pigments, natural pigments, fluorescent pigments, inorganic pigments, carbon black and the like.

Among these specific examples, carbon black is particularly preferred as a material, which absorbs a ray from near infrared to infrared to efficiently generate heat, and is economically competitive. At present, graft carbon blacks having various functional groups and having excellent dispersibility are commercially available and, for example, carbon blacks described in "Carbon Black Manual, 3rd edition, (edited by the Carbon Black Association) 1995, p. 167", "Characteristics of Carbon Black and Optimal Formulation and Applied Technology (Technical Information Association) 1997, p. 111", etc., can be preferably used in the present invention.

These pigments may be used without surface treatment or may be subjected to a known surface treatment. Examples of a known method include a method of surface-coating a resin or wax, a method of adhering a surfactant, and a method of bonding a reactive material such as a silane coupling agent or an epoxy compound, polyisocyanate to the surface of a pigment. These surface treating methods are described in "Kinzoku Sekken no Seishitsu to Ouyou" (Properties of Metal Soaps and Their Application) (Saiwai Shobo), "Saishin Ganryou Ouyou Gijutsu" (New Applied Technology for Pigment) (CMC Publishing, 1986), and "Insatsu Inki Gijutsu" (Printing Ink Technology) (CMC Publishing, 1984). The pigment used in the present invention preferably has a particle diameter within the range from 0.01 to 15 µm, and more preferably from 0.01 to 5 µm.

As the dye which can be used in the present invention, there can be used any known conventional dye and examples thereof include those described in "Senryou Binran" (Dye Manual) (edited by the Organic Synthesis Chemistry Association, 1970), "Shikizai Kougaku Handobukku" (Coloring Material Engineering Handbook) (edited by the Coloring Material Association, Asakura Shoten, 1989), "Kougyouyou Shikiso no Gijutsu to Shijyou" (Technology and Market of Industrial Coloring Matter) (edited by CMC, 1983), and "Kagaku Binran Ouyou Kagaku Hen" (Chemistry Manual-Applied Chemistry Version) (edited by the Japan Chemistry Society, Maruzen Shoten, 1986). More specific dyes thereof are azo dyes, metal complex azo dyes, pyrazolone azo dyes, anthraquinone dyes, phthalocyanine dyes, carbonium dyes, quinoneimine dyes, methine dyes, cyanine dyes, indigo dyes, quinoline dyes, nitro dyes, xanthene dyes, thiazine dyes, azine dyes, and oxazine dyes.

As the dye capable of efficiently absorbing near infrared rays or infrared rays, for example, there can be used azo dyes, metal complex salt azo dyes, pyrazolone azo dyes, naphthoquinone dyes, anthraquinone dyes, phthalocyanine dyes, carbonium dyes, quinoneimine dyes, methine dyes, cyanine dyes, squalirium dyes, pyrylium salt, and metal thiolate complexs (for example, nickel thioate complex. Among these dyes, cyanine dyes are preferred and examples thereof include cyanine dyes represented by the general formula (I) described in Japanese Unexamined Patent Publication (Kokai) No. 2001-305722 and compounds described in paragraphs [0096] to [0103] of Japanese Unexamined Patent Publication (Kokai) No. 2002-079772.

The photothermal conversion materials are particularly preferably dyes of the following formula: 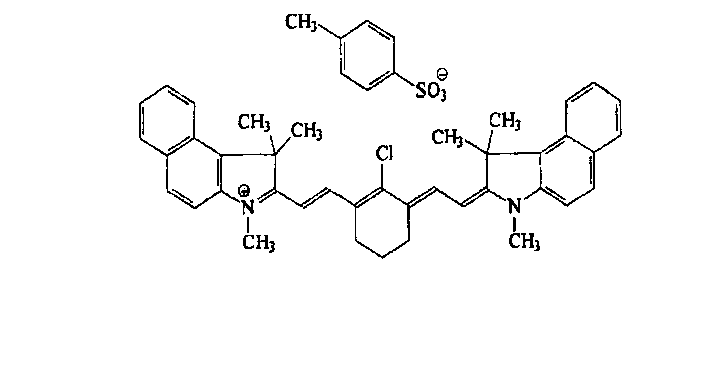 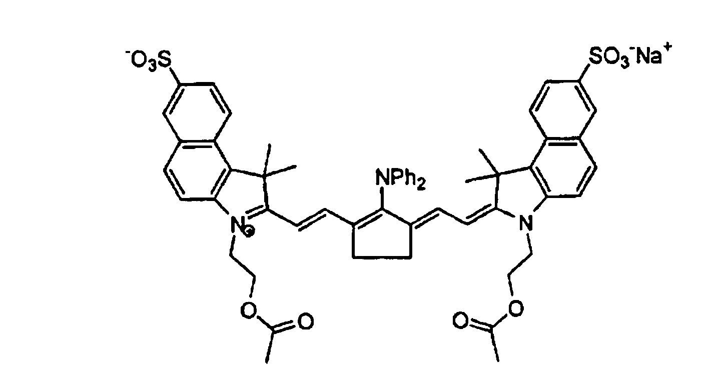 wherein Ph represents a phenyl group.
The photothermal conversion material can be added to the lower layer in an amount within a range from 0.01 to 50% by mass, preferably from 0.1 to 20% by mass, and particularly preferably from 1 to 15% by mass. When the amount is less than 0.01% by mass, sensitivity may decrease. In contrast, when the amount is more than 50% by mass, stains may be formed at the non-image area upon printing. These photothermal conversion materials may be used alone, or two or more kinds of them may be used in combination.

### <(a) Polymer having Perfluoroalkyl Group and (b) Polymer having Siloxane Group>

The lower layer of the lithographic printing original plate of the present invention contains (a) polymer having a perfluoroalkyl group and/or (b) polymer having a siloxane group as constituent components. It is considered that when these polymers are introduced into the lower layer and are unevenly distributed at the upper side in a thickness direction of the lower layer. Therefore, unevenness of roughness of the coated surface of the lower layer disappears, and the lower layer and the uppermost layer are likely to be dissociated upon exposure, and thus a developing speed is improved. Furthermore, heat generated from the lower layer upon exposure can be efficiently transferred to the upper layer area (improvement in an exposure speed) and a molecular structure of an alkali-soluble resin of the uppermost layer is efficiently collapsed to form large pores in the uppermost layer thereby enabling easy permeation of the developing solution into the bottom layer.

It is preferred that the polymer having a perfluoroalkyl group and the polymer having a siloxane group further have a polyoxyalkylene group, respectively.

Examples of the polymer having a perfluoroalkyl group (a) include the following polymers:
a perfluorooctylethyl methacrylate/2-hydroxyethyl methacrylate/N-phenylmaleimide copolymer, a perfluorooctylethyl methacrylate/2-hydroxyethyl methacrylate/benzyl methacrylate copolymer, a perfluorooctylethyl methacrylate/2-hydroxyethyl methacrylate/benzyl methacrylate/N-phenylmaleimide copolymer, and a perfluorooctylethyl acrylate/poly(oxypropylene) acrylate (n = 6) copolymer

Examples of the polymer having a siloxane group (b) include the following polymers:
polyether-modified polydimethylsiloxane, polyester-modified polydimethylsiloxane, polyester-modified hydroxyl group-containing polydimethylsiloxane, methylalkylpolysiloxane, and polyester-modified polymethylalkylsiloxane.

The lower layer can contain either the polymer having a perfluoroalkyl group or the polymer having a siloxane group. The lower layer may contain both of the polymer having a perfluoroalkyl group and the polymer having a siloxane group.

The amount of the polymer having a perfluoroalkyl group (a) or the polymer having a siloxane group (b) is usually from 1 to 20% by mass, and preferably from 3 to 10% by mass, based on the mass of the solid content of the lower layer. When the lower layer contains both polymers, the total amount of them is from 1 to 20% by mass, and preferably from 3 to 10% by mass. When the polymer having a perfluoroalkyl group (a) and the polymer having a siloxane group (b) are used in combination, a ratio of the polymer having a perfluoroalkyl group to the polymer having a siloxane group is preferably from 15:85 to 85:15 in terms of a mass ratio.

### <Constituent Components of Lower Layer and Uppermost Layer>

To the lower layer and/or the uppermost layer of the lithographic printing original plate of the present invention, known additives, for example, colorants (dyes, pigments), surfactants, plasticizers, stability improvers, development accelerators, development inhibitors, and lubricants (silicone powder, etc.) can be added, if necessary.

Examples of preferred dye include basic oil-soluble dyes such as Crystal Violet, Malachite Green, Victoria Blue, Methylene Blue, Ethyl Violet, and Rhodamine B. Examples of commercially available products include Victoria Pure Blue BOH (manufactured by Hodogaya Chemical Co., Ltd.), "Oil Bue #603" [manufactured by Orient Chemical Industries, Ltd.], "VPB-Naps (naphthalene sulfonate of Victoria Pure Blue)" [manufactured by Hodogaya Chemical Co., Ltd.], and "D11" [manufactured by PCAS]. Examples of the pigment include Phthalocyanine Blue, Phthalocyanine Green, Dioxadine Violet, and Quinacridone Red.

Examples of the surfactant include a fluorine-based surfactant and a silicone-based surfactant.

Examples of the plasticizer include diethyl phthalate, dibutyl phthalate, dioctyl phthalate, tributyl phosphate, trioctyl phosphate, tricresyl phosphate, tri(2-chloroethyl) phosphate, and tributyl citrate.

As the known stability improver, for example, phosphoric acid, phosphorous acid, oxalic acid, tartaric acid, malic acid, citric acid, dipicolinic acid, polyacrylic acid, benzenesulfonic acid and toluenesulfonic acid can be used in combination.

Examples of the other stability improver include known phenolic compounds, quinones, N-oxide compounds, amine-based compounds, sulfide group-containing compounds, nitro group-containing compounds, and transition metal compounds. Specific examples thereof include hydroquinone, p-methoxyphenol, p-cresol, pyrogallol, t-butylcatechol, benzoquinone, 4,4'-thiobis(3-methyl-6-t-butylphenol), 2,2'-methylenebis(4-methyl-6-t-butylphenol), 2-mercaptobenzimidazole, and N-nitrosophenylhydroxyamine primary cerium salt.

Examples of the development accelerator include acid anhydrides, phenols, and organic acids. Acid anhydrides are preferably cyclic anhydrides. As the cyclic anhydride, for example, there can be used phthalic anhydride, tetrahydrophthalic anhydride, hexahydrophthalic anhydride, 3,6-endoxy-tetrahydrophthalic anhydride, tetrachlorophthalic anhydride, maleic anhydride, chloromaleic anhydride, α-phenylmaleic anhydride, succinic anhydride, and pyromellitic anhydride described in U.S. Patent No. 4,115,128. Examples of the noncyclic acid anhydride include acetic anhydride. Examples of the phenols include bisphenol A, 2,2'-bishydroxysulfone, p-nitrophenol, p-ethoxyphenol, 2,4,4'-trihydroxybenzophenone, 2,3,4-trihydroxybenzophenone, 4-hydroxybenzophenone, 4,4',4"-trihydroxytriphenylmethane, and 4,4',3",4"-tetrahydroxy-3,5,3',5'-tetramethyltriphenylmethane.

Furthermore, examples of the organic acids include sulfonic acids, sulfinic acids, alkylsulfuric acids, phosphonic acids, phosphate esters, and carboxylic acids described in Japanese Unexamined Patent Publication (Kokai) No. 60-88942 and Japanese Unexamined Patent Publication (Kokai) No. 2-96755, and specific examples thereof are p-toluenesulfonic acid, dodecylbenzenesulfonic acid, p-toluenesulfinic acid, ethylsulfuric acid, phenylphosphonic acid, phenylphosphinic acid, phosphoric acid phenyl, phosphoric acid diphenyl, benzoic acid, isophthalic acid, adipic acid, p-toluic acid, 3,4-dimethoxybenzoic acid, phthalic acid, terephthalic acid, 4-cyclohexene-1,2-dicarboxylic acid, erucic acid, lauric acid, n-undecanoic acid, and ascorbic acid.

The development inhibitor is not particularly limited as long as it forms an interaction with the alkali-soluble resin, and substantially deteriorates solubility of the alkali-soluble resin in a developing solution in the unexposed area, while it becomes soluble in the developing solution in the exposed area since the interaction becomes lower. Among these, a quaternary ammonium salt and a polyethylene glycol-based compound are particularly preferably used. Among the above-mentioned infrared absorbers and colorants, compounds capable of functioning as a development inhibitor and are also preferably included. Further examples include materials, which has a pyrolytic property and substantially decrease solubility of an alkali-soluble resin in a state where it is not decomposed, such as an onium salt, an o-quinonediazide compound, an aromatic sulfone compound, and an aromatic sulfonate ester compound.

The amount of these various additives to be added varies depending on the purposes, and is preferably within a range from 0 to 30% by mass of the solid content of the lower layer or uppermost layer.

For the lower layer and/or the uppermost layer of the lithographic printing original plate of the present invention, the other alkali-soluble or dispersible resin can also be used in combination. Examples of the other alkali-soluble or dispersible resin include a polyester resin and an acetal resin.

The lithographic printing original plate of the present invention may contain a matting agent in the uppermost layer and a mat layer may be formed on the uppermost layer for the purpose of improving joined paper releasability and improving interleaving paper releasability and improving a plate transportation property.

### <Substrate>

Examples of the substrate include metal plates made of aluminum, zinc, copper, stainless steel, and iron; plastic films made of polyethylene terephthalate, polycarbonate, polyvinyl acetal, polyethylene, etc.; composite materials obtained by forming a metal layer on papers, plastic films which are melt-coated or coated with a synthetic resin solution, using technologies such as vacuum deposition and laminating; and a material used as the substrate of the printing plate. It is particularly preferred to use a substrate made of aluminum or a composite substrate coated with aluminum.

It is preferred that the surface of the aluminum substrate is surface-treated for the purpose of enhancing water retentivity and improving adhesion with a bottom layer or an optionally formed intermediate layer. Examples of the surface treatment include roughening treatments such as a brush graining method, a ball graining method, electrolytic etching, chemical etching, liquid honing, and sandblasting, and a combination thereof. Among these, a roughening treatment including use of electrolytic etching is particularly preferred.

As an electrolytic bath in the case of electrolytic etching, for example, an aqueous solution containing an acid, an alkali or a salt thereof, or an aqueous solution containing an organic solvent is used. Among these, an electrolytic solution containing hydrochloric acid, nitric acid, or a salt thereof is particularly preferred.

Furthermore, the aluminum substrate subjected to the roughening treatment is subjected to a desmutting treatment using an aqueous solution of an acid or an alkali, if necessary. It is preferred that the aluminum substrate thus obtained is subjected to an anodic oxidation treatment. It is particularly preferred that the anodic oxidation treatment is performed using a bath containing sulfuric acid or phosphoric acid.

If necessary, the aluminum substrate can be subjected to a silicate treatment (for example, sodium silicate, potassium silicate), a potassium fluorozirconate treatment, a phosphomolybdate treatment, an alkyl titanate treatment, a polyacrylic acid treatment, a polyvinylsulfonic acid treatment, a polyvinylphosphonic acid treatment, a phytic acid treatment, a treatment using a salt of a hydrophilic organic polymer compound and a divalent metal, a fused arylsulfonate treatment (for example, refers to GB Patent Publication No. 2,098,627 and Japanese Unexamined Patent Publication (Kokai) No. 57-195697), a hydropholization treatment by undercoating of a water-soluble polymer having a sulfonic acid group, a coloration treatment using an acid dye, and a treatment of silicate electrodeposition.

An aluminum substrate, which was subjected to a sealing treatment after subjecting to the roughening treatment (graining treatment) and the anodic oxidation treatment, is also preferred. The sealing treatment is performed by immersing an aluminum substrate in a hot aqueous solution containing hot water and an inorganic salt or an organic salt, or performed using a steam bath.

The lithographic printing original plate of the present invention is produced by dissolving or dispersing constituent components of a lower layer or an uppermost layer in organic solvents, sequentially coating the resultant solutions or dispersions on a substrate, and drying the solution or dispersion to form a lower layer on the substrate and to form an uppermost layer thereon.

As the organic solvent in which constituent components of the lower layer or the uppermost layer is dissolved or dispersed, conventionally known organic solvents can be used. In view of an advantage upon drying, an organic solvent having a boiling point within a range from 40 to 200°C, especially 60 to 160°C is selected.

Examples of the organic solvent include alcohols such as methyl alcohol, ethyl alcohol, n- or iso-propyl alcohol, n- or iso-butyl alcohol, and diacetone alcohol; ketones such as acetone, methyl ethyl ketone, methyl propyl ketone, methyl butyl ketone, methyl amyl ketone, methyl hexyl ketone, diethyl ketone, diisobutyl ketone, cyclohexanone, methylcyclohexanone, and acetylacetone; hydrocarbons such as hexane, cyclohexane, heptane, octane, nonane, decane, benzene, toluene, xylene, and methoxybenzene; acetate esters such as ethyl acetate, nor iso-propyl acetate, n- or iso-butyl acetate, ethylbutyl acetate, and hexyl acetate; halides such as methylene dichloride, ethylene dichloride, and monochlorobenzene; ethers such as isopropyl ether, n-butyl ether, dioxane, dimethyldioxane, and tetrahydrofuran; polyhydric alcohols such as ethylene glycol, ethylene glycol monomethyl ether, ethylene glycol monomethyl ether acetate, ethylene glycol monoethyl ether, ethylene glycol monoethyl ether acetate, ethylene glycol monobutyl ether, ethylene glycol monobutyl ether acetate, ethylene glycol dimethyl ether, ethylene glycol diethyl ether, ethylene glycol dibutyl ether, methoxyethoxyethanol, diethylene glycol monomethyl ether, diethylene glycol dimethyl ether, diethylene glycol methylethyl ether, diethylene glycol diethyl ether, propylene glycol, propylene glycol monomethyl ether, propylene glycol monomethyl ether acetate, propylene glycol monoethyl ether, propylene glycol monoethyl ether acetate, propylene glycol monobutyl ether, 3-methyl-3-methoxybutanol, and 1-methoxy-2-propanol, and a derivative thereof; and special solvents such as dimethyl sulfoxide, N,N-dimethylformamide, methyl lactate, and ethyl lactate. These organic solvents are used alone or in combination. The solid content of the solution or dispersion to be coated is preferably from 2 to 50% by mass. The solid content as used herein means components excluding the organic solvent and moisture.

As the method of coating the solutions or dispersions of constituent components of the lower layer and the uppermost layer, for example, methods such as roll coating, dip coating, air knife coating, gravure coating, gravure offset coating, hopper coating, blade coating, wire doctor coating, spray coating, and die coating methods can be used. The coating amount is preferably within a range from 10 to 100 ml/m².

The solution or dispersion coated on the substrate is usually dried by heated air. The drying temperature (temperature of heat air) is preferably within a range from 30 to 200°C, and particularly from 40 to 140°C. The solution or dispersion can also be dried by not only a method of maintaining the drying temperature at a given temperature during drying, but also a method of stepwisely raising the drying temperature.

Preferred results may be sometimes obtained by dehumidifying the drying air. The dry air is preferably supplied to the surface to be coated at a wind velocity within a range from 0.1 to 30 m/sec, and particularly preferably from 0.5 to 20 m/sec.

Each coating amount of the lower layer and the uppermost layer is usually within the range from about 0.1 to about 5 g/m² in terms of dry mass.

### <Exposure and Development>

The lithographic printing original plate of the present invention can be used as a CTP plate capable of directly writing an image on the plate in response on digital image information from a computer using a laser.

As a laser beam source in the present invention, a high-output laser having a maximum intensity in a near infrared to infrared region is used most preferably. Examples of the high-output laser having a maximum intensity in the near infrared to infrared region include various lasers, each having a maximum intensity in the near infrared to infrared region of 760 to 1200 nm, for example, a diode laser and a YAG laser.

After writing an image on an image recording layer using laser, the lithographic printing original plate of the present invention is treated by an image formation method which comprises development using a wet process to remove the non-image area (exposed area). That is, according to the image forming method of the present invention, an image is formed through the steps of imagewise exposing the lithographic printing original plate of the present invention; and developing the exposed lithographic printing original plate to remove the exposed area, thus forming an image area comprising a lower layer and an uppermost layer, and a non-image area.

In the lithographic printing original plate of the present invention, a developing solution used for development of a positive working PS plate is not used. The developing solution for a positive working PS plate contains, as main developing components, inorganic alkali compounds such as sodium silicate, potassium silicate, potassium hydroxide, sodium hydroxide, lithium hydroxide, a sodium, potassium or ammonium salt of a secondary or tertiary phosphoric acid, sodium methasilicate, sodium carbonate, and ammonia and usually has high pH (pH of 12 or higher). When a silicate is used, insoluble aluminum sludge may be produced, and thus there arises a problem such as high frequency of replacement of the solution.

The lithographic printing original plate of the present invention is characterized by developing using a developing solution for a negative working PS plate. The aqueous alkali aqueous solution (basic aqueous solution) used for a development treatment preferably has pH of lower than 12.

Examples of an alkali agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, N-2-hydroxyethylenediamine, and benzylamine, and these alkali agents may be used alone, or two or more kinds of them may be used in combination.

The content of the alkali agent in the developing solution is preferably within a range from 0.01 to 20% by mass, and particularly preferably from 0.1 to 5% by mass. When the content of the alkali agent in the developing solution is less than 0.01% by mass, poor development may arise. In contrast, when the content is more than 20% by mass, an adverse influence such as erosion of the image area may be exerted upon development, and thus it is not preferred.

Organic solvents can also be added to the developing solution. Examples of the organic solvent include ethyl acetate, butyl acetate, amyl acetate, benzyl acetate, ethylene glycol monobutyl acetate, butyl lactate, butyl levulinate, methyl ethyl ketone, ethyl butyl ketone, methyl isobutyl ketone, cyclohexanone, ethylene glycol monobutyl ether, ethylene glycol monobenzyl ether, ethylene glycol monophenyl ether, benzyl alcohol, methylphenylcarbitol, n-amyl alcohol, methylamyl alcohol, xylene, methylene dichloride, ethylene dichloride, monochlorobenzene, 2-phenoxyethanol, methylcyclohexanol, cyclohexanol, ethylene glycol dibutyl ether, cyclohexanone, methylcyclohexanone, and n-butyl ethyl ketone. When the organic solvent is added to the developing solution, the amount of the organic solvent is preferably 30% by mass or less, and particularly preferably 10% by mass or less.

If necessary, the above developing solution may contain water-soluble sulfites such as lithium sulfite, sodium sulfite, potassium sulfite, and magnesium sulfite; hydroxy aromatic compounds such as alkali-soluble pyrazoline compounds, alkali-soluble thiol compounds, and methyl resorcine; water softeners such as polyphosphate and aminopolycarboxylic acids; various surfactants, for example, anionic surfactants such as sodium isopropylnaphthalene sulfonate, sodium n-butylnaphthalene sulfonate, sodium N-methyl-N-pentadecyl aminoacetate, and lauryl sulfate sodium salt, nonionic surfactants, cationic surfactants, amphoteric surfactants and fluorine-based surfactants; and various defoamers.

As the developing solution, a commercially available developing solution for a negative working PS plate is practically used. Specifically, a solution prepared by diluting a commercially available concentrated developing solution for a negative working PS plate by 1 to 1,000 times can be used as the developing solution in the present invention.

The temperature of the developing solution is preferably within a range from 15 to 40°C, while the immersion time is preferably within a range from 1 second to 2 minutes. If necessary, the surface can be slightly rubbed during the development.

The developed lithographic printing plate is washed with water and/or subjected to a treatment using an aqueous surface protecting solution (finishing gum). The aqueous surface protecting solution includes, for example, a water-soluble natural polymer such as gum arabic, dextrin, or carboxymethyl cellulose; and an aqueous solution containing a water-soluble synthetic polymer such as polyvinyl alcohol, polyvinyl pyrrolidone, or polyacrylic acid. If necessary, acids and surfactants are added to these aqueous surface protecting solutions. After subjecting to a treatment using a surface protecting solution, the lithographic printing plate was dried and used for printing as the printing plate.

For the purpose of improving press life of the resultant lithographic printing plate, the lithographic printing plate can also be subjected to a baking treatment after the development treatment.

A baking treatment is carried out by (i) washing the lithographic printing plate obtained by the above treating method to remove a rinsing solution or a gum solution, followed by squeezing, (ii) spreading a counter-etching solution over the entire plate without causing unevenness, followed by drying, (iii) performing burning under the temperature conditions of 180 to 300°C in an oven for 1 to 30 minutes, and (iv) washing the plate with water to remove the counter-etching solution, followed by gumming and further drying.

The lithographic printing original plate of the present invention as described above can provide a high-resolution positive image using infrared laser, and is also excellent in resistance to a UV ink washing agent and is suited for UV ink printing since a bottom layer itself has solvent resistance.

### EXAMPLES

The present invention will be described in more detail by way of Examples. However, the present invention is not limited to the following Examples.

### Production of Substrate

An aluminum plate having a thickness of 0.24 mm was degreased with an aqueous sodium hydroxide solution and then subjected to an electrolytic graining treatment in a 20% hydrochloric acid bath to obtain a grained plate having a center line average roughness (Ra) of 0.5 µm. The aluminum plate was subjected to an anodic oxidation treatment in a 20% sulfuric acid bath at a current density of 2 A/dm² to form an oxide film of 2.7 g/m². After washing with water and drying, an aluminum substrate was obtained. The substrate thus obtained was immersed in a solution for an interlayer treatment (polyvinylphosphonic acid) heated to 60°C for 10 seconds, washed with water and then dried. Thus, a substrate for a lithographic printing plate was obtained.

### Synthesis of Binder Resin for Photosensitive Layer

In a 10 liter four-necked flask equipped with a stirrer, a condenser tube and a dropping funnel, 2,990 g of dimethyl acetamide was charged and then heated to 90°C. 740.5 g of phenylmaleimide, 1,001 g of methacrylamide, 368 g of methacrylic acid, 643 g of acrylonitrile, 203.6 g of Phosmer-MM [manufactured by Uni-Chemical Co., Ltd.], 222.5 g of styrene, 10.6 g of AIBN and 16 g of n-dodecylmercaptan were dissolved in 2,670 g of dimethylacetamide and the resultant solution was added dropwise in a reaction apparatus over 2 hours. After completion of the dropwise addition, 5.3 g of AIBN was added and the temperature was raised to 100°C, followed by stirring for 4 hours. During stirring, 5.3 g of AIBN was added every one hour and the reaction was continued.

After the completion of the reaction, heating was terminated, followed by cooling to 60°C. The reaction solution was dropped in 50 liter of water and the resultant precipitate was collected by vacuum filtration, washed once with water and then collected again by vacuum filtration. After vacuum drying at 60°C for 24 hours, a resin 1 was obtained. The amount of the resin 1 was 2,873 g (yield: 90%). A weight average molecular weight measured by GPC was 51,000.

### Preparation of Coating Solution for Lower Layer

In the preparation of a coating solution (for coating a lower layer) of the following photosensitive composition shown in Table 1, the kind and the amount of (a) a polymer having a perfluoroalkyl group or (b) a polymer having a siloxane group were varied.

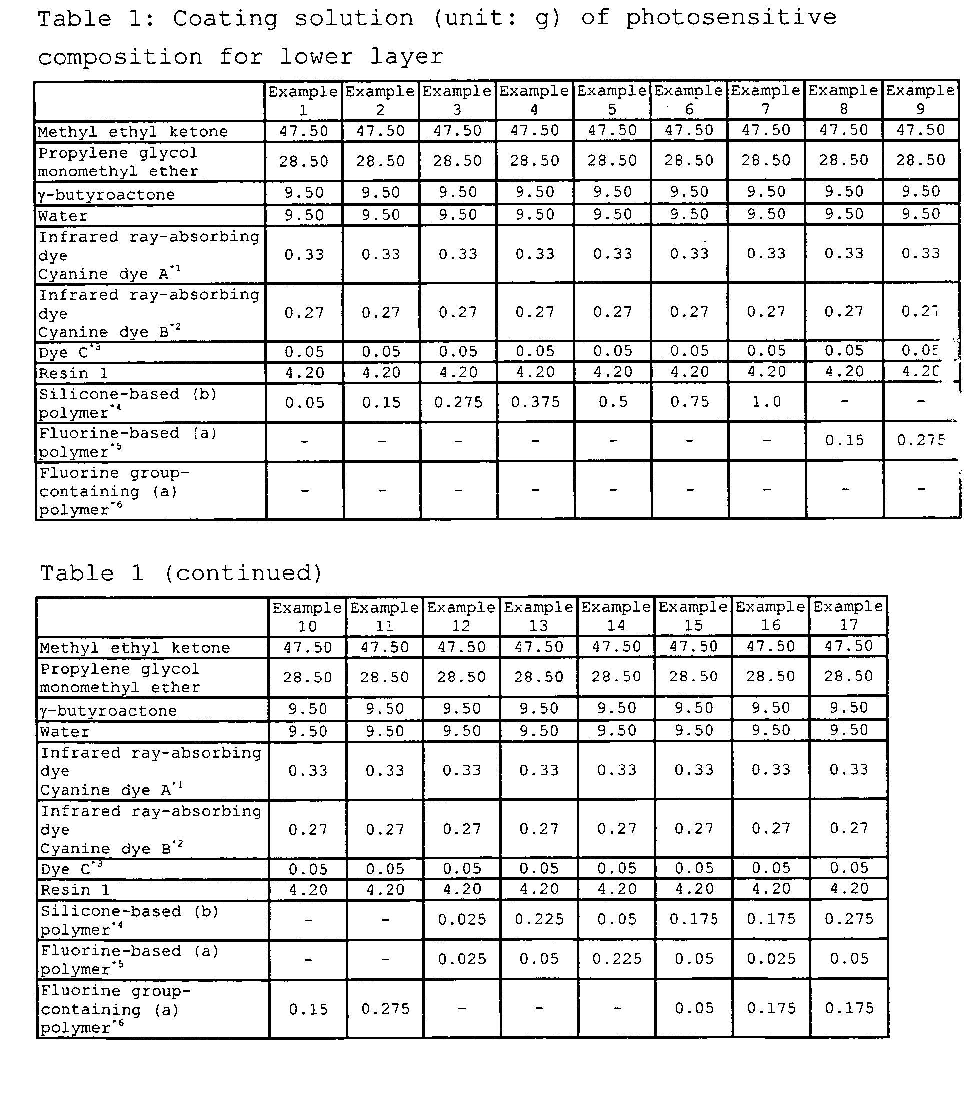

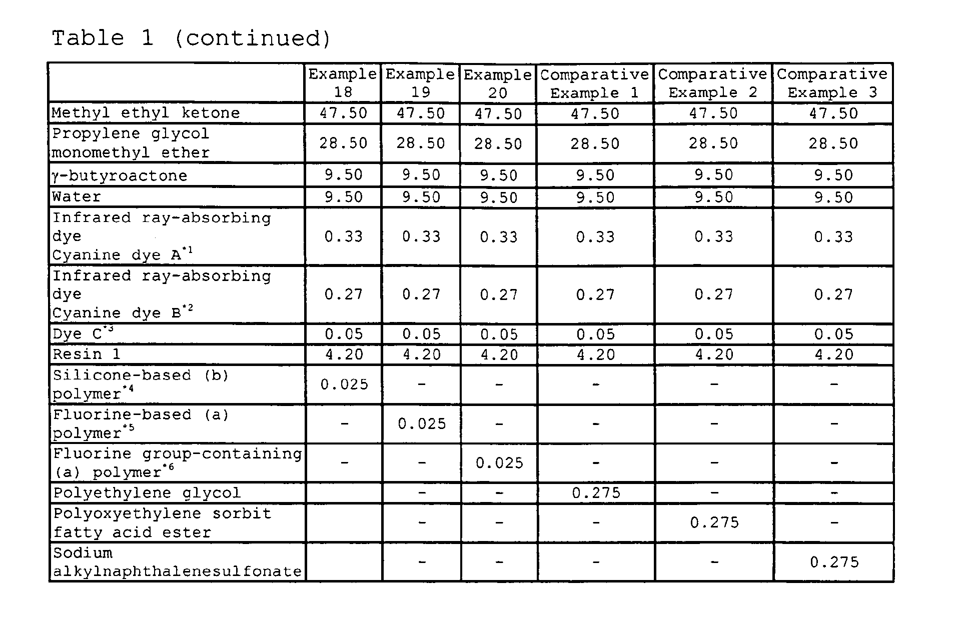

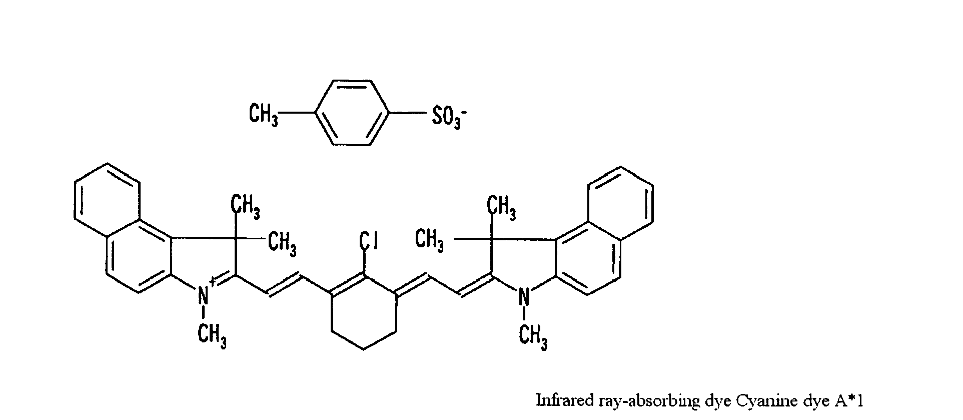

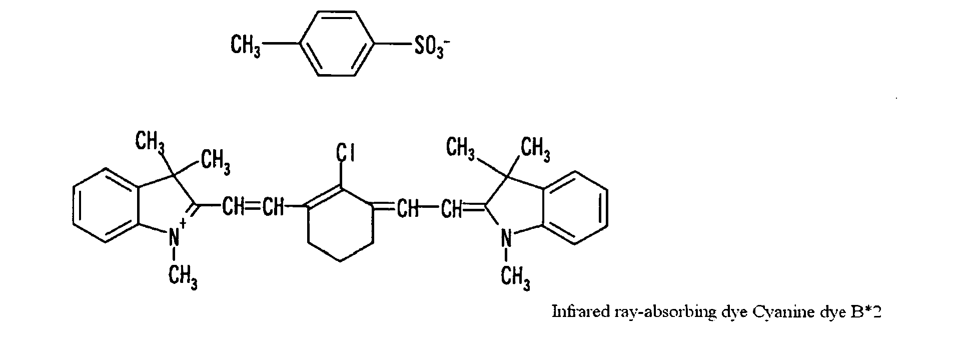

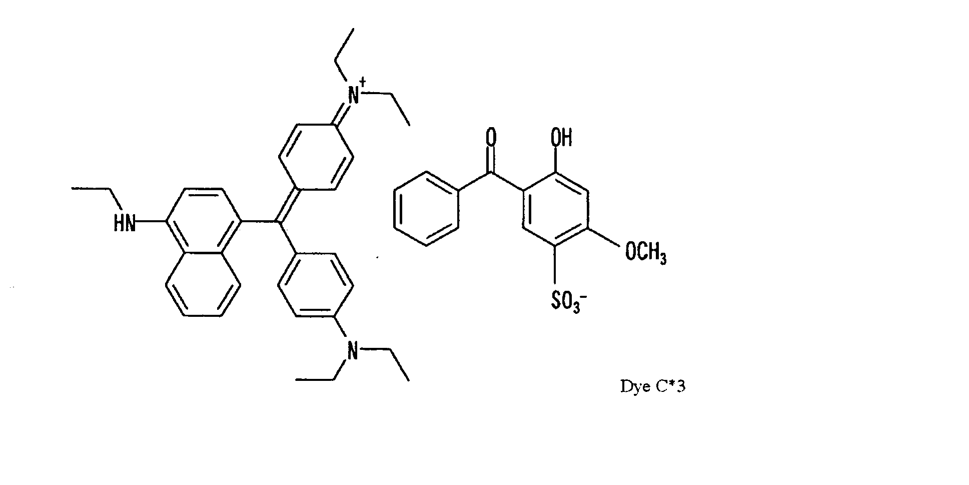

Silicone-based (b) polymer^{*4} "BYK-331" (manufactured by BYK Chemie)
Polyether/dimethylpolysiloxane copolymer fluorine-based (a) polymer^{*5}
Perfluorooctylethyl acrylate/poly(oxypropylene) acrylate (n = 6) copolymer (molar ratio 35/65)
Fluorine group-containing (a) polymer^{*6}
Perfluorooctylethyl methacrylate/2-hydroxyethyl methacrylate/benzyl methacrylate/N-phenylmaleimide copolymer
(Molar ratio 30/20/10/40)

### Preparation of Coating Solution for Uppermost Layer

A coating solution (uppermost layer) of the following photosensitive composition shown in Table 2 was prepared.

**Table 2: Coating solution of composition for uppermost layer**

| | Unit: g |
|---|---|
| Methyl isobutyl ketone | 66.32 |
| Acetone | 19.00 |
| Propylene glycol monomethyl ether acetate | 9.50 |
| SMA resin (weight average molecular weight: 2,000) | 4.93 |
| Colorant dye C^{*3} | 0.02 |
| Silicone-based b polymer^{*4} | 0.05 |

| | |
|---|---|
| SMA resin: Copolymer of styrene and maleic anhydride (molar ratio 1:1) "SMA resin (weight average molecular weight: 2,000)" | |

### Production of Lithographic Printing Original Plate

The photosensitive solution composition prepared as shown in Table 1 was coated on the substrate produced by the above method using a roll coater and then dried at 100°C for 2 minutes. At this time, the amount of a dry coating film was 1.5 g/m². A coating solution of the uppermost layer composition prepared according to the formulation shown in Table 2 was coated on each lower layer and then dried at 100°C for 2 minutes. The amount of a dry coating film of the uppermost layer was 0.5 g/m².

### Preparation of Developing Solution

According to the formulation shown in Table 3, a developing solution was prepared. The pH was 11.5 and conductivity was 9 mS/cm.

**Table 3: Composition of developing solution**

| | Unit: g |
|---|---|
| Deionized water | 700 |
| Monoethanolamine | 10 |
| Diethanolamine | 30 |
| PELEX NBL manufactured by Kao Corporation | 200 |
| Benzyl alcohol | 60 |

### Evaluation Method

### (Appearance)

Using a roll coater, a coating solution of a photosensitive composition for a lower layer was coated on a substrate and, after completion of drying, coatability was confirmed. Less unevenness on the coated surface shows good appearance.

### (Sensitivity)

The resultant two-layer type lithographic printing original plate was exposed at different exposure using "PTR4300" [manufactured by DAINIPPON SCREEN MFG CO., LTD.] and then subjected to a development treatment at 30°C for 15 seconds using an automatic processor "P-1310X" [manufactured by Kodak Graphic Communications Japan Ltd.] and a developing solution prepared by diluting the developing solution obtained in Table 3 with water by 5 times. In the case where the development can be performed in a lower exposure upon development, it shows higher sensitivity.

### (Ink Receptivity)

The resultant two-layer type lithographic printing original plate was exposed at 150 mJ/cm² using "PTR4300" [manufactured by DAINIPPON SCREEN MFG CO., LTD.], developed at 30°C for 15 seconds using an automatic processor "P-1310X" [manufactured by Kodak Graphic Communications Japan Ltd.] and a developing solution prepared by diluting the developing solution obtained in Table 3 with water by 5 times and then subjected to gumming using Finishing Gum "PF2" [manufactured by Kodak Graphic Communications Japan Ltd.] to obtain a lithographic printing plate.

Using the resultant lithographic printing plate and a printer "R-201" [manufactured by MANROLAND CO., LTD.], a coated paper, printing ink "Space Color Fusion G-Magenta" [manufactured by Dainippon Ink and Chemicals, Incorporated.] and dampening-water "NA-108W", concentration of 1% [manufactured by Dainippon Ink and Chemicals, Incorporated.], isopropyl alcohol (IPA) having a concentration of 1%, printing was initiated and the number of printed sheets, until a printed sheet having a completely reproduced pattern was obtained, was confirmed. The smaller the number of printed sheets means better initial ink receptivity.

The evaluation results are shown in Table 4. In all evaluations, a score of 5 shows the excellent (A) results, while a score of 1 shows the worst (E).

**Table 4: Evaluation Results**

| | Appearance | Sensitivity | Ink receptivity |
|---|---|---|---|
| Example 1 | 5 | 2 | 2 |
| Example 2 | 3 | 4 | 3 |
| Example 3 | 3 | 5 | 3 |
| Example 4 | 3 | 5 | 3 |
| Example 5 | 2 | 5 | 3 |
| Example 6 | 1-2 | 5 | 3 |
| Example 7 | 1-2 | 5 | 3 |
| Example 8 | 5 | 3 | 3 |
| Example 9 | 5 | 3 | 4 |
| Example 10 | 3 | 3 | 4 |
| Example 11 | 2 | 3 | 5 |
| Example 12 | 4 | 2 | 3 |
| Example 13 | 4 | 5 | 3 |
| Example 14 | 5 | 3 | 4 |
| Example 15 | 5 | 5 | 5 |
| Example 16 | 3 | 4 | 5 |
| Example 17 | 3 | 4 | 5 |
| Example 18 | 2 | 2 | 1 |
| Example 19 | 2 | 2 | 2 |
| Example 20 | 1-2 | 2 | 2 |
| Comparative Example 1 | 1 | 1 | 2 |
| Comparative Example 2 | 1 | 1 | 2 |
| Comparative Example 3 | 1 | 1 | 2 |

It was confirmed that, in order to enhance the sensitivity in this example, a nonionic surfactant and an anionic surfactant are not effective and (a) a polymer having a perfluoroalkyl group and/or (b) a polymer having a siloxane group are effective. Use of the polymer (a) and 1 to 20% by mass of the polymer (b) alone or in combination showed good results when compared with the case of the use of the polymer (a) and 0.25% by mass of the polymer (b) alone. In particular, use of the polymer (a) and 3 to 10% by mass of the polymer (b) alone or in combination showed good results, and well-balanced sensitivity, appearance and initial ink receptivity were obtained. In particular, use of 5.5 % of the polymer (a) and the polymer (b) in combination (Example 15) showed good results.

The present invention can provide a photosensitive lithographic printing original plate which is capable of directly making a plate based on digital information from a computer and has well-balanced excellent characteristics.

## Claims

1. A positive working lithographic printing original plate having (1) a substrate thereon (2) a lower layer containing a water-insoluble and alkali-soluble resin and a photothermal conversion material, and (3) an uppermost layer containing a water-insoluble and alkali-soluble resin, wherein
the lower layer contains (a) a polymer having a perfluoroalkyl group and/or (b) a polymer having a siloxane group.

2. The positive working lithographic printing original plate according to claim 1, wherein the total amount of the polymer (a) and/or the polymer (b) in the solid content of the lower layer is from 3 to 10% by mass.

3. The positive working lithographic printing original plate according to claim 1 or 2, wherein the polymer having a perfluoroalkyl group further comprises a polyoxyalkylene group.

4. The positive working lithographic printing original plate according to claim 1 or 2, wherein the polymer having a siloxane group further comprises a polyoxyalkylene group.

5. The positive working lithographic printing original plate according to any one of claims 1 to 4, wherein a ratio of the polymer (a) and the polymer (b) in the lower layer is from 15:85 to 85:15 in terms of a mass ratio.

6. The positive working lithographic printing original plate according to any one of claims 1 to 5, wherein the uppermost layer is substantially free of a photothermal conversion material.

7. The positive working lithographic printing original plate according to any one of claims 1 to 6, wherein the uppermost layer is soluble in an alkali developer having pH of lower than 12.

8. The positive working lithographic printing original plate according to any one of claims 1 to 7, wherein the uppermost layer contains a copolymer having a carboxylic acid group or an acid anhydride group.

9. A plate-making method of a positive working lithographic printing original plate comprising imagewise exposing the positive working lithographic printing original plate according to claim 1, and developing the positive working lithographic printing original plate with a developing solution for a negative working PS plate.
